# EUROPÄISCHE PATENTANMELDUNG

(11) **EP 1 826 475 A1**
(43) Veröffentlichungstag der Anmeldung: **29.08.2007**
(21) Anmeldenummer: 06003772.8
(22) Anmeldetag: 24.02.2006
(51) Int. Cl.: F21S 8/10, G02B 3/04, H01L 33/00, F21V 7/00, F21V 5/00, F21V 5/04

(54) **Flache Leuchtvorrichtung mit LED und Lichtleiter**

(71) Anmelder: Delphi Technologies, Inc., Troy, MI 48007 (US)
(72) Erfinder: Felgenhauer, Reinhard, 58636 Iserlohn (DE); Haack, Albrecht, 42369 Wuppertal (DE)
(74) Vertreter: Manitz, Finsterwald & Partner GbR

(57) **Zusammenfassung**

Die Erfindung betrifft eine flache Leuchtvorrichtung mit einer Lichtquelle und einem Lichtleiter, in den das von der Lichtquelle ausgestrahlte Licht mittels einer Parallelisier-/Umlenkeinheit lenkbar ist, welche ein Linsenelement zum Parallelisieren und ein Reflexionselement zum Umlenken des von der Lichtquelle ausgestrahlten Lichts umfasst.

## Beschreibung

Die Erfindung betrifft eine flache Leuchtvorrichtung, insbesondere eine Rückleuchte für ein Kraftfahrzeug, mit wenigstens einem Leuchtelement, wobei jedes Leuchtelement eine Lichtquelle und einen Lichtleiter aufweist, in den das von der Lichtquelle ausgestrahlte Licht mittels einer Parallelisier-/Umlenkeinheit lenkbar ist, welche ein Linsenelement zum Parallelisieren und ein Reflexionselement zum Umlenken des von der Lichtquelle ausgestrahlten Lichts umfasst.

Derartige Leuchtvorrichtungen sind grundsätzlich bekannt und werden in Kraftfahrzeugen beispielsweise als Bremsleuchten oder als Fahrtrichtungsanzeiger eingesetzt. Als Lichtquellen werden bevorzugt Leuchtdioden (LEDs) verwendet, da diese im Vergleich zu z.B. Glühlampen eine höhere Lebensdauer, geringere Schaltzeiten sowie einen reduzierten Stromverbrauch aufweisen.

Die Abstrahlcharakteristik von Leuchtvorrichtungen der eingangs genannten Art wird letztlich durch die Gestaltung des Lichtleiters bestimmt. Dabei ist es bei einer vorgegebenen Lichtleitergestalt zur Erreichung einer gewünschten Abstrahlcharakteristik mit entscheidend, dass möglichst viel des von den LEDs ausgestrahlten Lichts unter einem optimalen Winkel in den Lichtleiter einkoppelt. Dies erweist sich bei bekannten LED-Leuchtvorrichtungen jedoch als problematisch.

Der Erfindung liegt die Aufgabe zugrunde, eine Leuchtvorrichtung mit einer wirksameren Einkopplung des von der Lichtquelle emittierten Lichts in den Lichtleiter zu schaffen.

Zur Lösung der Aufgabe ist eine Leuchtvorrichtung mit den Merkmalen des Anspruchs 1 vorgesehen.

Die erfindungsgemäße flache Leuchtvorrichtung, insbesondere Rückleuchte für ein Kraftfahrzeug, umfasst wenigstens ein Leuchtelement, wobei jedes Leuchtelement eine Lichtquelle und einen Lichtleiter aufweist, in den das von der Lichtquelle ausgestrahlte Licht mittels einer Parallelisier-/Umlenkeinheit lenkbar ist. Die Parallelisier-/Umlenkeinheit umfasst ein Linsenelement zum Parallelisieren und ein Reflexionselement zum Umlenken des von der Lichtquelle ausgestrahlten Lichts, wobei das Linsenelement und das Reflexionselement eine durch die Lichtquelle verlaufende optische Achse definieren.

Das Linsenelement ist so ausgebildet, dass es zumindest einen der optischen Achse nahen Teil des ausgestrahlten Lichts zumindest annähernd parallelisiert auf das Reflexionselement lenkt. Vorzugsweise handelt es sich bei dem Linsenelement um ein asphärisches Linsenelement.

Die Parallelisier-/Umlenkeinheit weist ferner eine das Linsenelement umgebende Wand auf, die so ausgebildet ist, dass ein nicht in das Linsenelement eingetretener und die Wand durchlaufender Teil des ausgestrahlten Lichts zumindest annähernd parallel zu dem durch das Reflexionselement umgelenkten Licht aus der Wand austritt.

Die Parallelisier-/Umlenkeinheit verfügt mit anderen Worten über zwei Sorten von Parallelisier-/Umlenkmittel, nämlich zum einen über das Linsenelement und das Reflexionselement für die achsnahen Lichtstrahlen und zum anderen über die das Linsenelement umgebende Wand für die nicht durch das Linsenelement eingefangenen achsfernen Lichtstrahlen. Durch die Parallelisierung und Umlenkung nicht nur der achsnahen, sondern auch der achsfernen Lichtstrahlen kann insgesamt mehr Licht in den Lichtleiter einkoppeln.

Darüber hinaus werden die durch das Linsenelement und das Reflexionselement einerseits und durch die Wand andererseits umgelenkten Lichtstrahlen alle zumindest annähernd um den gleichen Winkel bezüglich der optischen Achse umgelenkt. Sowohl die achsnahen, als auch die achsfernen Lichtstrahlen können somit unter im wesentlichen dem gleichen Winkel in den Lichtleiter einkoppeln.

Erfindungsgemäß wird also nicht nur eine besonders große Lichtmenge in den Lichtleiter eingekoppelt, sondern das Licht tritt auch unter einem für die Lichtleitung optimalen Winkel in den Lichtleiter ein. Der Lichtleiter kann seine Funktion somit optimal erfüllen, wodurch die gewünschte Abstrahlcharakteristik, insbesondere eine optimale Helligkeit, der Leuchte erreicht wird.

Vorteilhafte Ausbildungen der Erfindung sind den Unteransprüchen, der Beschreibung und der Zeichnung zu entnehmen.

Gemäß einer bevorzugten Ausführungsform ist das Reflexionselement so ausgebildet, dass es eine Umlenkung der Lichtstrahlen um zumindest annähernd 90° bezüglich der optischen Achse bewirkt. Das von der Lichtquelle emittierte Licht kann somit unter einem rechten Winkel zur Hauptabstrahlrichtung der Lichtquelle in den Lichtleiter eintreten.

Das Linsenelement kann durch eine konvexe Erhöhung in einer durch die Wand begrenzten Aussparung der Parallelisier-/Umlenkeinheit gebildet sein. Das Reflexionselement kann dagegen durch eine, insbesondere kegelförmige, Vertiefung in der Parallelisier-/Umlenkeinheit gebildet sein. Beides erleichtert die Herstellung der Parallelisier-/Umlenkeinheit, insbesondere wenn diese einstückig ausgebildet ist.

Gemäß einer weiteren Ausführungsform ist die Parallelisier-/Umlenkeinheit bezüglich der optischen Achse rotationssymmetrisch ausgebildet. Eine derartige Parallelisier-/Umlenkeinheit lässt sich z.B. mittels Fräsen leicht herstellen. Außerdem ermöglicht sie eine Umlenkung des von der Lichtquelle ausgestrahlten Lichts in einen die optischen Achse umgebenden Winkelbereich von 360°.

Vorteilhafterweise ist die Parallelisier-/Umlenkeinheit ein separates Bauteil. Die Parallelisier-/Umlenkeinheit kann somit unabhängig von dem Lichtleiter hergestellt und gegebenenfalls für verschiedene Typen von Lichtleitern verwendet werden. Durch die Ausbildung der Parallelisier-/Umlenkeinheit als separates Bauteil können außerdem die Justierung der optischen Elemente aufgeteilt und somit die einzelnen Fertigungstoleranzen ausgeglichen werden.

Gemäß einer weiteren Ausführungsform ist die Parallelisier-/Umlenkeinheit in einer Aussparung des Lichtleiters untergebracht. Dies erleichtert nicht nur die Montage der Parallelisier-/Umlenkeinheit an dem Lichtleiter, sondern gegebenenfalls auch eine Trennung von Parallelisier-/Umlenkeinheit und Lichtleiter, z.B. bei einer Beschädigung der Lichtquelle, der Parallelisier-/Umlenkeinheit und/oder des Lichtleiters.

Damit das Linsenelement, das Reflexionselement und die Wand der Parallelisier-/Umlenkeinheit ihre jeweilige optische Funktion optimal erfüllen können, ist eine exakte Ausrichtung der Parallelisier-/Umlenkeinheit mit der Lichtquelle erforderlich. Genauer gesagt sollte die durch das Linsenelement und das Reflexionselement definierte optische Achse möglichst parallel zu der Hauptabstrahlrichtung und durch das Zentrum der Lichtquelle verlaufen. Um eine exakte Positionierung der Parallelisier-/Umlenkeinheit bezüglich der Lichtquelle zu erleichtern, kann ein Positioniermittel vorgesehen sein.

Das Positioniermittel kann beispielsweise eine Aufnahme der Parallelisier-/Umlenkeinheit für die Lichtquelle und/oder für einen Träger der Lichtquelle umfassen. Alternativ oder zusätzlich kann das Positioniermittel einen Rastmechanismus aufweisen, durch den die Parallelisier-/Umlenkeinheit und die Lichtquelle und/oder ein Träger der Lichtquelle miteinander verrastbar sind. Sowohl die Aufnahme, als auch der Rastmechanismus stellen bei einer Montage der Lichtquelle an der Parallelisier-/Umlenkeinheit eine gewünschte Sollrelativlage der Lichtquelle bezüglich der Parallelisier-/Umlenkeinheit sicher.

Gemäß einer weiteren Ausführungsform ist der Lichtleiter, insbesondere an seiner zur Lichtquelle weisenden Seite, d.h. also an seiner Rückseite, mit einer Auskoppelstruktur für das eingekoppelte Licht versehen, welche eine Vielzahl von, insbesondere stufenartig angeordneten, vorzugsweise planen oder gekrümmten, Reflexionsflächen aufweist. Die Reflexionsflächen können alle gleich ausgebildet sein. Alternativ ist es jedoch auch möglich, zumindest einige der Reflexionsflächen unterschiedlich zu formen. Beispielsweise können die Reflexionsflächen ausgehend von der Lichtquelle zum Rand des Lichtleiters hin, gewissermaßen also von innen nach außen, mit einer sich graduell ändernden Gestalt ausgebildet sein. Die Gestaltung der Reflexionsflächen ermöglicht es, eine Vielzahl von unterschiedlichen optischen Effekten zu erzeugen und somit in nahezu beliebiger Weise die Abstrahlcharakteristik der Leuchtvorrichtung einzustellen.

Nachfolgend wird die Erfindung rein beispielhaft anhand einer vorteilhaften Ausführungsform unter Bezugnahme auf die Zeichnung beschrieben.
Es zeigen:
- Fig. 1: eine Teilquerschnittsansicht eines Leuchtelements einer erimdungsgemäßen Leuchtvorrichtung;
- Fig. 2: eine Draufsicht auf eine Rückseite des Leuchtelements von Fig. 1; und
- Fig. 3: eine Draufsicht auf die Vorderseite einer aus mehreren Leuchtelementen zusammengesetzten Leuchtvorrichtung.

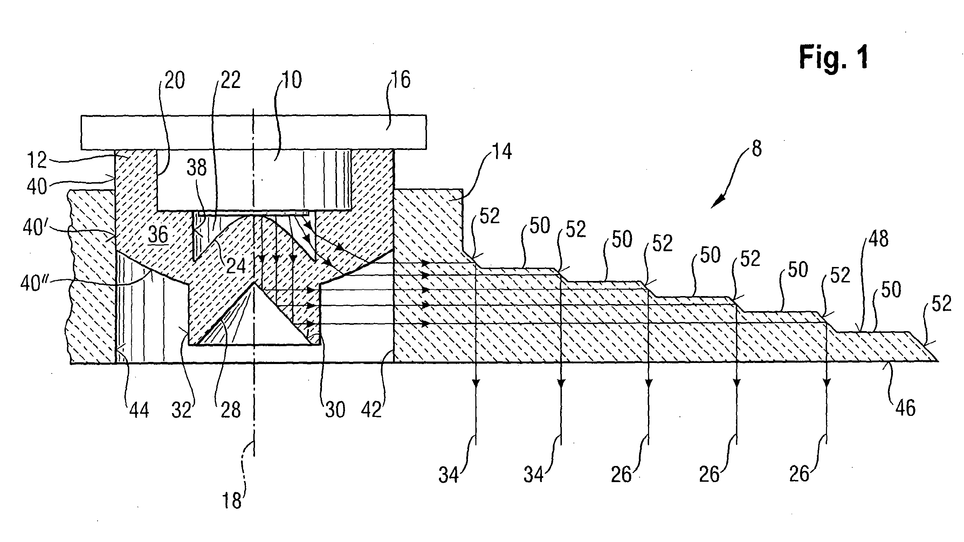

Eine erfindungsgemäße Leuchtvorrichtung weist mindestens ein Leuchtelement 8 auf, welches, wie in Fig. 1 dargestellt ist, eine Lichtquelle 10, eine Parallelisier-/Umlenkeinheit 12 und einen Lichtleiter 14 umfasst. Die Leuchtvorrichtung kann als Fahrzeugheckleuchte, z.B. Bremsleuchte, Rücklicht, Rückfahrleuchte oder Fahrtrichtungsanzeiger, verwendet werden.

Bei der Lichtquelle 10 handelt es sich um eine Leuchtdiode (LED), die an einem Träger 16 montiert ist. Der Träger 16 umfasst eine elektrische Schaltung zum Versorgen der LED 10 mit Strom bzw. Spannung. Der Träger 16 kann z.B. eine flexible gedruckte Schaltung (FPC), eine Leiterplatte (PCB) oder einen spritzgegossenen Schaltungsträger (MID) aufweisen.

Die Parallelisier-/ Umlenkeinheit 12 ist einstückig aus einem für das von der LED 10 ausgestrahlte Licht durchlässigen Material, z.B. einem Kunststoffmaterial, gebildet. Das Material der Parallelisier-/Umlenkeinheit 12 kann zur Erzielung eines gewünschten Farbeffekts eingefärbt sein.

Die Parallelisier-/Umlenkeinheit 12 weist eine zylindrische Grundform auf und ist bezüglich einer Längsmittelachse 18, welche nachfolgend auch als optische Achse bezeichnet wird, rotationssymmetrisch ausgebildet.

An der einen Stirnseite der Parallelisier-/Umlenkeinheit 12 ist eine Aufnahmeaussparung 20 zur Aufnahme der LED 10 vorgesehen. Der Querschnitt der Aufnahmeaussparung 20 ist an den Querschnitt der LED 10 angepasst, so dass die LED 10 im Wesentlichen spielfrei in der Parallelisier-/Umlenkeinheit 12 sitzt. Durch das Zusammenwirken von Aufnahmeaussparung 20 und LED 10 ist eine korrekte Positionierung der LED 10 in der Parallelisier-/Umlenkeinheit 12 sichergestellt.

Alternativ oder zusätzlich kann auch ein nicht gezeigter Rastmechanismus zur Verrastung von Parallelisier-/Umlenkeinheit 12 und Träger 16 vorgesehen sein.

Die Aufnahmeaussparung 20 geht in einen zylindrischen Hohlraum 22 über, in den die LED 10 geringfügig hineinragt. Ein der LED 10 abgewandter Boden des Hohlraums 22 wölbt sich unter Bildung einer um die optische Achse 18 rotationssymmetrischen konvexen Erhöhung 24 in den Hohlraum 22 hinein.

Die Oberfläche der Erhöhung 24 ist so geformt, dass die Erhöhung 24 als ein asphärisches Linsenelement für das von der LED 10 ausgestrahlte Licht wirkt. Dabei ist das Linsenelement 24 so ausgebildet, dass von der LED 10 emittierte Lichtstrahlen 26, die eine gewisse Nähe zur optischen Achse 18 aufweisen und/oder mit der optischen Achse 18 einen ausreichend kleinen Winkel bilden, in das Linsenelement 24 eintreten und dabei zumindest annähernd parallel zur optischen Achse 18 ausgerichtet, d.h. also parallelisiert werden.

An der der Aufnahmeaussparung 20 abgewandten Stirnseite der Parallelisier-/Umlenkeinheit 12 ist eine kegelförmige Vertiefung 28 ausgebildet, deren Symmetrieachse ebenfalls mit der optischen Achse 18 zusammenfällt. Die Kegelmantelfläche 30 bildet eine Reflexionsfläche für die durch das Linsenelement 24 parallelisierten Lichtstrahlen 26. Dabei ist die Neigung der Kegelmantelfläche 30 so gewählt, dass die auftreffenden parallelisierten Lichtstrahlen 26 um etwa 90° umgelenkt werden.

Über eine zur optischen Achse 18 parallele zylindrische Außenfläche 32 können die umgelenkten Lichtstrahlen 26 zumindest annähernd rechtwinklig zur optischen Achse 18 aus der Parallelisier-/Umlenkeinheit 12 austreten.

Von der LED 10 emittierte achsferne Lichtstrahlen 34 bzw. Lichtstrahlen 34, die mit der optischen Achse 18 einen einen Grenzwinkel überschreitenden Winkel bilden, laufen an dem Linsenelement 24 vorbei oder werden an dessen Oberfläche reflektiert. Ein Teil dieser Lichtstrahlen 34 tritt in eine den Hohlraum 22 umgebende zylindrische Wand 36 ein, die eine an den Hohlraum 22 begrenzende Innenfläche 38 und eine Außenfläche 40 aufweist.

Die Wandinnenfläche 38 ist parallel zur optischen Achse 18 orientiert. Die Wandaußenfläche 40 weist dagegen einen ebenfalls parallel zur optischen Achse 18 orientierten Abschnitt 40' sowie einen Freiformflächenabschnitt 40" auf. Der Freiformflächenabschnitt 40" ist derart geformt, dass die die Wand 36 durchlaufenden Lichtstrahlen 34 an der Wandaußenfläche 40 so umgelenkt werden, dass sie zumindest annähernd rechtwinklig zu der optischen Achse 18 aus der Wand 36 austreten und somit parallel zu den durch die Kegelmantelfläche 30 reflektierten Lichtstrahlen 26 verlaufen.

Die Parallelisier-/Umlenkeinheit 12 bewirkt somit eine Parallelisierung und Umlenkung nicht nur der achsnahen Lichtstrahlen 26 bzw. der Lichtstrahlen 26, die unter einem ausreichend kleinen Winkel bezüglich der optischen Achse 18 aus der LED 10 austreten, sondern auch von achsfernen Lichtstrahlen 34 bzw. Lichtstrahlen 34, die unter einem den Grenzwinkel überschreitenden Winkel bezüglich der optischen Achse 18 aus der LED 10 austreten.

Die parallelisierten und umgelenkten Lichtstrahlen 26, 34 können somit optimal in den Lichtleiter 14 einkoppeln.

Der Lichtleiter 14 weist eine scheibenförmige Grundgestalt auf und ist in an sich bekannter Weise aus einem für das von der LED 10 ausgestrahlte Licht durchlässigen Material gebildet, z.B. aus einem Kunststoffmaterial. Ähnlich wie das Material der Parallelisier-/Umlenkeinheit 12 kann auch das Material des Lichtleiters 14 zur Erzielung eines gewünschten Farbeffekts eingefärbt sein.

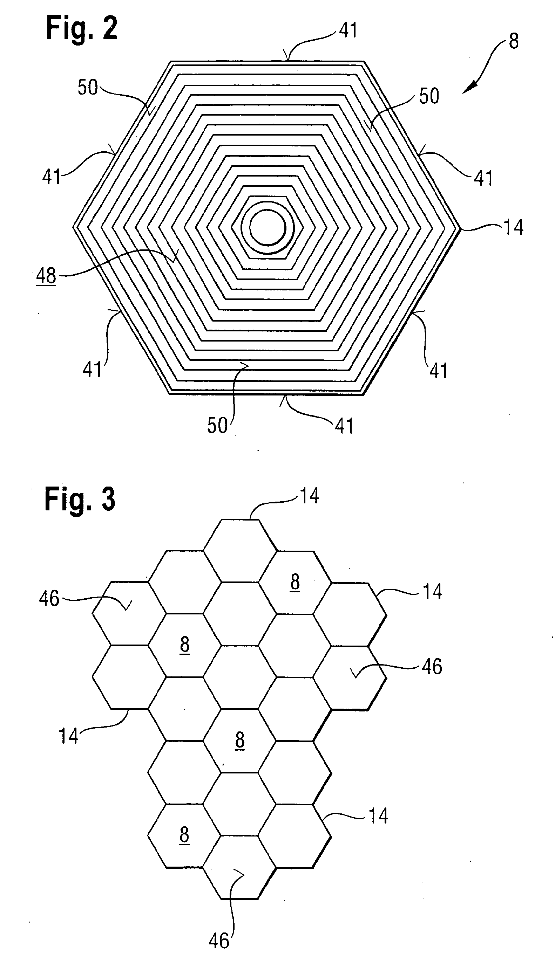

Bei der dargestellten Ausführungsform besitzt der Lichtleiter 14 die Gestalt einer sechseckigen Scheibe, wobei der Abstand zwischen jeweils gegenüberliegenden Scheibenseiten 41 mehrere 10 mm, z.B. 30 mm, betragen kann (Fig. 2). Die Sechseckform des Lichtleiters 14 ermöglicht eine besonders dichte Anordnung von mehreren gleichartigen Leuchtelementen 8, wodurch eine nahezu beliebig große homogene Abstrahlfläche realisiert werden kann (Fig. 3). Alternativ kann der Lichtleiter 14 auch eine andere mehreckige Gestalt aufweisen oder rund ausgebildet sein. Durch eine entsprechende Gestaltung des Lichtleiters 14 können nicht nur verschiedene Formen der Leuchtvorrichtung, sondern auch unterschiedliche optische Effekte erzielt werden.

Wie Fig. 1 zeigt, weist der Lichtleiter 14 in seinem Zentrum eine zylindrische Bohrung 42 auf, welche zur zumindest teilweisen Aufnahme der Parallelisier-/Umlenkeinheit 12 dient. Über die die Bohrung 42 begrenzende Wandfläche 44 des Lichtleiters 14 kann das durch die Parallelisier-/Umlenkeinheit 12 umgelenkte Licht 26, 34 in den Lichtleiter 14 einkoppeln.

Der Durchmesser der Bohrung 42 braucht nicht exakt an den maximalen Außendurchmesser der Parallelisier-/Umlenkeinheit 12 angepasst zu sein, da aufgrund der parallelen Ausrichtung des aus der Parallelisier-/Umlenkeinheit 12 austretenden Lichts selbst bei einer vergleichsweise ungenauen Positionierung der Parallelisier-/Umlenkeinheit 12 relativ zu dem Lichtleiter 14 kaum Lichtverluste auftreten. Die Parallelisierung des von der LED 10 ausgestrahlten Lichts durch die Parallelisier-/Umlenkeinheit 12 bedeutet mit anderen Worten also, dass an die bei dem Zusammenbau von Parallelisier-/Umlenkeinheit 12 und Lichtleiter 14 einzuhaltenden Toleranzen geringere Anforderungen gestellt werden können, wodurch die Montage des Leuchtelements 8 und somit der Leuchtvorrichtung insgesamt erheblich vereinfacht wird und folglich kostengünstiger durchführbar ist. Dies gilt insbesondere dann, wenn die Leuchtvorrichtung aus einer Vielzahl von Leuchtelementen 8 gebildet ist (Fig. 3).

Wichtig ist jedoch, dass die Parallelisier-/Umlenkeinheit 12 mit einer möglichst hohen Genauigkeit bezüglich der LED 10 positioniert wird. Da die Parallelisier-/Umlenkeinheit 12 ein einstückig ausgebildetes Bauteil ist, kann die Positionierung der Parallelisier-/Umlenkeinheit 12 bereits nach der Montage der LED 10 auf dem Träger 16 geschehen. Wie bereits erwähnt sitzt die Parallelisier-/Umlenkeinheit 12 bei der dargestellten Ausführungsform passgenau auf der LED 10. Alternativ oder zusätzlich kann auch ein nicht gezeigter Rastmechanismus zur Verrastung von Parallelisier-/Umlenkeinheit 12 und Träger 16 vorgesehen sein.

Bei dem dargestellten Ausführungsbeispiel ist der Lichtaustritt aus dem Lichtleiter 14 an der senkrecht zur optischen Achse 18 orientierten und der LED 10 abgewandten Hauptfläche 46 des Lichtleiters 14 vorgesehen, die nachfolgend auch als Vorderseite bzw. Lichtaustrittsseite bezeichnet wird. Grundsätzlich ist es auch möglich, den Lichtaustritt an der der LED 10 zugewandten Rückseite 48 des Lichtleiters 14 vorzusehen.

Damit das in den Lichtleiter 14 eingekoppelte und zunächst rechtwinklig zur optischen Achse 18, d.h. also parallel zur Vorderseite 46, durch den Lichtleiter 14 laufende Licht 26, 34 an der Vorderseite 46 des Lichtleiters 14 aus diesem austreten kann, ist an der der Vorderseite 46 abgewandten Rückseite 48 des Lichtleiters eine Auskoppelstruktur vorgesehen, die eine Vielzahl von "konzentrisch" angeordneten Auskoppelrippen 50 umfasst. Alternativ kann die Auskoppelstruktur auch an der Vorderseite 46 vorgesehen sein.

Die Auskoppelrippen 50 fallen von der optischen Achse 18 aus gesehen zum Rand des Lichtleiters 14 hin treppen- bzw. kaskadenartig ab, wodurch sich der Querschnitt des Lichtleiters 14 nach außen hin verjüngt. Die Auskoppelrippen 50 bilden Reflexionsflächen 52, durch welche die rechtwinklig zur optischen Achse 18 durch den Lichtleiter 14 laufenden Lichtstrahlen 26, 34 umgelenkt und aus dem Lichtleiter 14 heraus gelenkt werden.

Die Form der Auskoppelrippen 50 beeinflusst die Abstrahlcharakteristik des Leuchtelements 8 und somit der Leuchtvorrichtung insgesamt. Durch eine entsprechende Ausbildung der Auskoppelrippen 50, insbesondere durch eine entsprechende Neigung und/oder Krümmung der Reflexionsflächen 52, ist es beispielsweise möglich streuende oder bündelnde Leuchtvorrichtungen zu schaffen. Bei der dargestellten Ausführungsform sind die Reflexionsflächen so ausgebildet, dass das Licht 26, 34 im wesentliche rechtwinklig umgelenkt wird und in einer zur optischen Achse 18 zumindest annähernd parallelen Richtung aus dem Lichtleiter 14 austritt.

### Bezugszeichenliste

- 8: Leuchtelement
- 10: Lichtquelle
- 12: Parallelisier- /Umlenkeinheit
- 14: Lichtleiter
- 16: Träger
- 18: optische Achse
- 20: Aufnahmeaussparung
- 22: Hohlraum
- 24: Linsenelement
- 26: Lichtstrahl
- 28: Vertiefung
- 30: Kegelmantelfläche
- 32: Außenfläche
- 34: Lichtstrahl
- 36: Wand
- 38: Innenfläche
- 40: Außenfläche
- 41: Scheibenseite
- 42: Bohrung
- 44: Wandfläche
- 46: Vorderseite
- 48: Rückseite
- 50: Auskoppelrippe
- 52: Reflexionsfläche

## Patentansprüche

1. Flache Leuchtvorrichtung, insbesondere Rückleuchte für ein Kraftfahrzeug, mit wenigstens einem Leuchtelement (8), wobei jedes Leuchtelement (8) eine Lichtquelle (10) und einen Lichtleiter (14) aufweist, in den das von der Lichtquelle (10) ausgestrahlte Licht mittels einer Parallelisier-/Umlenkeinheit (12) lenkbar ist, welche ein Linsenelement (24) zum Parallelisieren und ein Reflexionselement (30) zum Umlenken des von der Lichtquelle (10) ausgestrahlten Lichts umfasst, wobei
das Linsenelement (24) und das Reflexionselement (30) eine durch die Lichtquelle (10) verlaufende optische Achse (18) definieren,
das Linsenelement (24) so ausgebildet ist, dass es zumindest einen der optischen Achse (18) nahen Teil (26) des ausgestrahlten Lichts zumindest annähernd parallelisiert auf das Reflexionselement (30) lenkt, und
die Parallelisier-/Umlenkeinheit (12) ferner eine das Linsenelement (24) umgebende Wand (36) aufweist, die so ausgebildet ist, dass ein nicht in das Linsenelement (24) eingetretener und die Wand (36) durchlaufender Teil (34) des ausgestrahlten Lichts zumindest annähernd parallel zu dem durch das Reflexionselement (30) umgelenkten Licht (26) aus der Wand (36) austritt.

2. Leuchtvorrichtung nach Anspruch 1,
**dadurch gekennzeichnet, dass**
das Linsenelement (24) ein asphärisches Linsenelement ist.

3. Leuchtvorrichtung nach Anspruch 1 oder 2,
**dadurch gekennzeichnet, dass**
das Linsenelement (24) durch eine konvexe Erhöhung in einer durch die Wand (36) begrenzten Aussparung (22) der Parallisier-/Umlenkeinheit (12) gebildet ist.

4. Leuchtvorrichtung nach einem der vorherigen Ansprüche,
**dadurch gekennzeichnet, dass**
das Reflexionselement (30) so ausgebildet ist, dass es eine Umlenkung des Lichts (26) um zumindest annähernd 90° bezüglich der optischen Achse (18) bewirkt.

5. Leuchtvorrichtung nach einem der vorherigen Ansprüche,
**dadurch gekennzeichnet, dass**
das Reflexionselement (30) durch eine, insbesondere kegelförmige, Vertiefung (28) in der Parallelisier-/Umlenkeinheit (12) gebildet ist.

6. Leuchtvorrichtung nach einem der vorherigen Ansprüche,
**dadurch gekennzeichnet, dass**
die Parallelisier-/Umlenkeinheit (12) bezüglich der optischen Achse (18) rotationssymmetrisch ausgebildet ist.

7. Leuchtvorrichtung nach einem der vorherigen Ansprüche,
**dadurch gekennzeichnet, dass**
die Parallelisier-/Umlenkeinheit (12) einstückig ausgebildet ist.

8. Leuchtvorrichtung nach einem der vorherigen Ansprüche,
**dadurch gekennzeichnet, dass**
die Parallelisier-/Umlenkeinheit (12) ein separates Bauteil ist.

9. Leuchtvorrichtung nach einem der vorherigen Ansprüche,
**dadurch gekennzeichnet, dass**
die Parallelisier-/Umlenkeinheit (12) in einer Aussparung (20) des Lichtleiters (14) untergebracht ist.

10. Leuchtvorrichtung nach einem der vorherigen Ansprüche,
**dadurch gekennzeichnet, dass**
ein Positioniermittel vorgesehen ist, welches eine exakte Positionierung der Parallelisier-/Umlenkeinheit (12) bezüglich der Lichtquelle (10) ermöglicht.

11. Leuchtvorrichtung nach Anspruch 10,
**dadurch gekennzeichnet, dass**
das Positioniermittel eine Aufnahme (20) der Parallelisier-/Umlenkeinheit (12) für die Lichtquelle (10) und/oder für einen Träger (16) der Lichtquelle (10) umfasst.

12. Leuchtvorrichtung nach Anspruch 10 oder 11,
**dadurch gekennzeichnet, dass**
das Positioniermittel einen Rastmechanismus umfasst, durch den die Parallelisier-/Umlenkeinheit (12) und die Lichtquelle (10) und/oder ein Träger (16) der Lichtquelle (10) miteinander verrastbar sind.

13. Leuchtvorrichtung nach einem der vorherigen Ansprüche,
**dadurch gekennzeichnet, dass**
der Lichtleiter (14), insbesondere an seiner zur Lichtquelle (10) weisenden Seite (48), mit einer Auskoppelstruktur für das in den Lichtleiter (14) eingekoppelte Licht versehen ist, die eine Vielzahl von, insbesondere stufenartig angeordneten, vorzugsweise planen oder gekrümmten, Reflexionsflächen (52) aufweist.

14. Leuchtvorrichtung nach Anspruch 13,
**dadurch gekennzeichnet, dass**
alle Reflexionsflächen (52) gleich ausgebildet sind, oder unterschiedlich geformte Reflexionsflächen (52) vorgesehen sind.

## Geänderte Patentansprüche

### Geänderte Patentansprüche gemäss Regel 86(2) EPÜ.

**1.** Flache Leuchtvorrichtung, insbesondere Rückleuchte für ein Kraftfahrzeug, mit wenigstens einem Leuchtelement (8), wobei jedes Leuchtelement (8) eine Lichtquelle (10) und einen Lichtleiter (14) aufweist, in den das von der Lichtquelle (10) ausgestrahlte Licht mittels einer Parallelisier-/Umlenkeinheit (12) lenkbar ist, welche ein Linsenelement (24) zum Parallelisieren und ein Reflexionselement (30) zum Umlenken des von der Lichtquelle (10) ausgestrahlten Lichts umfasst, wobei
das Linsenelement (24) und das Reflexionselement (30) eine durch die Lichtquelle (10) verlaufende optische Achse (18) definieren,
das Linsenelement (24) so ausgebildet ist, dass es zumindest einen der optischen Achse (18) nahen Teil (26) des ausgestrahlten Lichts zumindest annähernd parallelisiert auf das Reflexionselement (30) lenkt, und
die Parallelisier-/Umlenkeinheit (12) ferner eine das Linsenelement (24) umgebende Wand (36) aufweist, die so ausgebildet ist, dass ein nicht in das Linsenelement (24) eingetretener und die Wand (36) durchlaufender Teil (34) des ausgestrahlten Lichts zumindest annähernd parallel zu dem durch das Reflexionselement (30) umgelenkten Licht (26) aus der Wand (36) aus- und in den Lichtleiter (14) eintritt.
